# EUROPEAN PATENT SPECIFICATION

(11) **EP 2 592 633 B1**
(45) Date of publication and mention of the grant of the patent: **14.06.2017**
(21) Application number: 11009025.5
(22) Date of filing: 14.11.2011
(51) Int. Cl.: H01C 1/082, H01C 1/02

(54) **Liquid-cooled resistor device**
Flüssigkeitsgekühlte Widerstandsvorrichtung
Dispositif de résistance à refroidissement par liquide

(43) Date of publication of application: 15.05.2013
(73) Proprietor: Cressall Resistors Limited, Leicester LE5 5LZ (GB)
(72) Inventor: Nazzaro, Giuseppe, LE5 5LZ Leicester (GB)
(74) Representative: Rapisardi, Mariacristina

(56) References cited:
- EP-A2- 0 454 904
- WO-A2-2005/041627
- DE-A1- 3 204 683
- DE-A1- 3 933 956
- JP-A- 2000 252 101

## Description

The present invention relates to a liquid-cooled resistor device.

Liquid-cooled resistor devices known from the prior art can be employed in a wide variety of applications, including regenerative braking of devices using an inverter-driven electric motor which can also function as a generator.

DE 3933956 discloses a liquid-cooled resistor device for use in electric vehicles, with a flat resistor mounted between two liquid-cooled, electrically insulated blocks. The resistor is kept in place simply by rigid connection between the two blocks. GB2478547 discloses a liquid-cooled brake resistor device for use in electric vehicles, with a flat resistor is disposed between a liquid-cooled, electrically insulated block and a blocking plate or a further liquid-cooled block. The resistor is kept in place by rigid connection between the block and the blocking plate, or between the two blocks, as well as by expansion guide means at last partially surrounding the resistor to confine expansion in its main plane.

One of the drawbacks of the devices of the prior art is that the thermal contact resistance at the resistor-block or resistor-insulation layer interface limits the efficiency and efficacy of the heat transfer. Moreover, the low heat capacity of the block relative to the cooling liquid limits the overall rate of heat dissipation from the resistor.

Further, for use of the devices for braking inverter-driven electric motors, relatively large resistors and liquid-cooled blocks are required in order to manage the high energy dissipation requirements involved, which can in practice render the devices bulky and heavy.

The technical task proposed by the present invention is therefore that of providing a liquid-cooled resistor device that overcomes the noted technical drawbacks of the prior art.

Within the scope of this technical task, one object of the invention is that of providing a liquid-cooled resistor device having improved efficiency and efficacy of heat dissipation from the resistor.

Another object of the invention is that of providing a liquid-cooled resistor device that is compact and lightweight.

A last but not least object of the invention is that of providing a liquid-cooled resistor device that is safe and economical.

The technical task, as well as these and other objects, are achieved according to the present invention by a liquid-cooled resistor device according to claim 1.

The use of elastic pressing means forcing the thermally conductive, electrically insulating flat layer against the resistor ensures improved heat transfer between the resistor and the flat layer. Moreover, the closure of the cavity of the block by the flat layer and the placement of the elastic pressing means in the cavity improves the heat transfer from the layer to the liquid. The overall heat transfer efficiency and efficacy improvement allows the device of the invention to be smaller and lighter than those of the noted prior art.

Furthermore, the use of elastic pressing means increases the stiffness of the device in a direction perpendicular to the plane of the resistor, thereby bringing it substantially above the characteristic vibration frequencies of vehicles and rolling stock. Hence, the device is better able to withstand vibration and shock during use.

Other characteristics of the present invention are moreover defined in the subsequent claims. Further characteristics and advantages of the present invention will be more evident from the description of a preferred, but not exclusive, embodiment of the liquid-cooled resistor device according to the finding, illustrated in the attached non-limiting drawing, wherein:

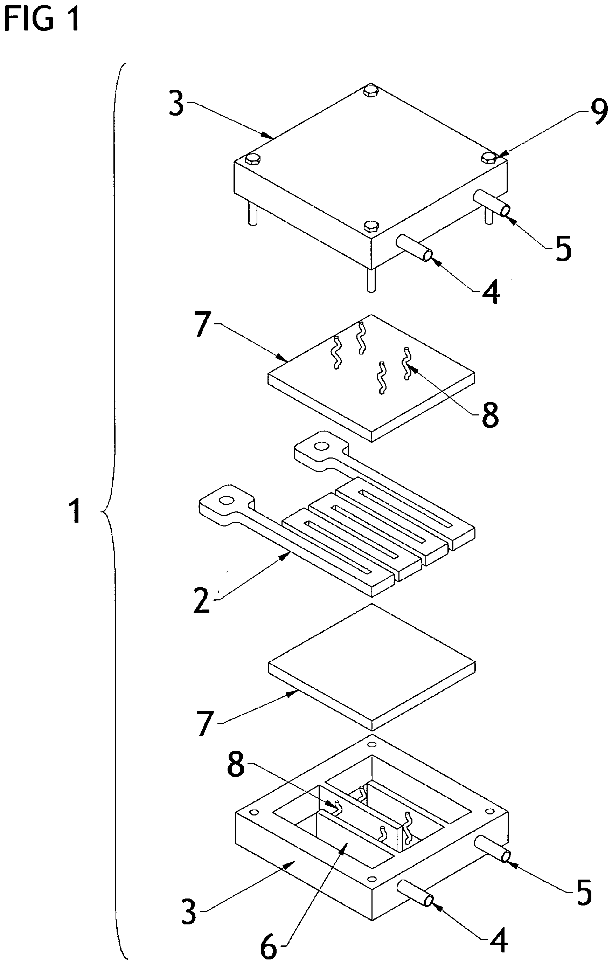

Figure 1 shows an exploded view of one embodiment of the invention.

With reference to the above figure, the liquid-cooled resistor device (generally indicated by 1), comprises a resistor (2), preferably in the form of a flat grid of electrically resistive material. The electrical connection of said resistor (2) to a power circuit is preferably by terminals which are part of or connected to the resistor (2).

The resistor (2) rests on a thermally conductive, electrically insulating flat layer (7), disposed such that their main planes are parallel to one another. The flat layer (7) is preferably made of aluminium nitride ceramic and comprises a rigid sheet.

At least one block (3) is provided, preferably made of an electrically and thermally insulating material, in particular preferably moulded thermoset plastic. It is provided with a liquid inlet (4) and a liquid outlet (5), preferably disposed parallelly and as a function of the width of said block. The block further has a cavity provided with a liquid flow path (6) between the inlet (4) and the outlet (5). Advantageously, the cavity can be machined in the face of the block (6) that is oriented towards the resistor (2), such that the cavity has an open side that can be closed by the thermally conductive, electrically insulating flat layer (7).

Preferably, the cavity has a peripheral shoulder on which said flat layer (7) rests. In this way the liquid flow path (6) is closed and the liquid cannot contact the resistor (2).

Preferably, the flow path (6) covers the same footprint as the maximum area of the resistor (2) in order to maximise energy dissipation. Advantageously, the liquid used for cooling can be water and it is preferably introduced into the flow path (6) at a flow rate sufficiently high to sustain turbulent flow throughout the flow path.

Preferably, the peaks of the partitioning walls defining the liquid flow path (6) within the cavity are spaced apart from the layer (7) such that a small bypass of liquid over said peaks is possible. This prevents dry regions on the flat layer (7) in the footprint of the resistor (2), in turn avoiding hot spots that could impair heat transfer and the integrity of the device.

An electrically insulated blocking plate is provided, rigidly fastenable to the block (3), with the resistor (2) being blocked between the blocking plate and the flat layer (7). Preferably, the blocking plate comprises a further block (3) with a further thermally conductive, electrically insulating layer (7) disposed between the further block (3) and the resistor (2), as shown in Figure 1. Preferably, the two blocks (3) are rigidly fastenable to one another via fastening rivets (9).

Elastic pressing means are disposed between the block (3) and the thermally conductive, electrically insulating flat layer (7), subjecting said flat layer (7) to a force against resistor (2). In particular, the elastic pressing means are housed in the cavity of the block (3). Preferably, the elastic pressing means are configured so as to force the flat layer (7) against the resistor (2) with an almost uniform contact pressure at the contact area between the flat layer (7) and the resistor (2). The elastic means comprise a plurality of springs (8) disposed in the internal liquid flow path (6) of the block (3). Preferably, each of the springs (8) is disposed with its axis perpendicular to said internal liquid flow path (6). Preferably the springs (8) are made of stainless steel.

In the arrangement wherein a block (3) is present on each side of the resistor (2) as shown in Figure 1, the springs (8) are configured so as to provide a force distributed across a face of each of the flat layers (7), providing tight contact between the resistor (2) and each of the flat layers (7). In addition to improving the heat transfer between the resistor (2) and the thermally conductive, electrically insulating flat layer (7), the presence of the springs in the internal liquid flow path (6) of the block (3) increases the turbulence of the liquid flow, which in turn improves the heat transfer from the thermally conductive, electrically insulating flat layer (7) to the liquid. The springs also decrease the cross-section of the internal liquid flow path (6), thereby increasing the speed of the liquid flow and hence the heat transfer rate from the flat layer (7) to the liquid without increasing the required volumetric flow rate of liquid.

Overall, the presence of the elastic pressing means provides a 200-300% increase in heat transfer from the resistor (2), in turn enabling the device to be made smaller and lighter than those of the prior art. The use of thermoset plastic for the block (3) further aids the compact and lightweight construction of the device.

Optionally, the device comprises expansion guide means (not shown) disposed between fins of the resistor (2) to confine the expansion of the resistor in its main plane in order to prevent mutual contact between the fins of the resistor and subsequent short-circuiting. Preferably, the expansion guide means comprise at least one mica paper strip. The thickness of this at least one strip is advantageously no more than that of the resistor (2) so as to not impede the contact between the resistor (3) and the insulating layer (7).

The liquid-cooled resistor device thus conceived is susceptible to numerous modifications and variations, all falling within the scope of the inventive concept; furthermore, all details may be substituted by technically equivalent elements.

In practice, any material type or size may be used, according to the needs and the state of the art.

## Claims

1. Liquid-cooled resistor device (1) comprising a block (3) having a liquid inlet (4), a liquid outlet (5) and a cavity, said cavity having an open side closed by a thermally conductive, electrically insulating flat layer (7) supporting a flat resistor (2) with their main planes parallel to one another, said device further comprising an electrically insulating blocking plate, rigidly fastenable to said block (3), facing said resistor (2) to block said resistor (2) on said flat layer (7), said cavity housing elastic pressing means configured so as to force said flat layer (7) against said resistor (2), **characterised in that** said cavity is provided with a liquid flow path (6) between said liquid inlet (4) and said liquid outlet (5), said elastic pressing means comprising a plurality of springs (8) disposed in said internal liquid flow path (6) of said block (3).

2. Liquid-cooled resistor device (1) as claimed in claim 1, **characterised in that** said elastic pressing means are configured so as to force said flat layer (7) against said resistor (2) with an almost uniform contact pressure at the contact area therebetween.

3. Liquid-cooled resistor device (1) as claimed in claim 1 or 2, **characterised in that** each of said springs (8) is disposed with an axis perpendicular to said internal liquid flow path (6).

4. Liquid-cooled resistor device (1) as claimed in any preceding claim, **characterised in that** said springs (8) are made of stainless steel.

5. Liquid-cooled resistor device (1) as claimed in any preceding claim, **characterised in that** said electrically insulated blocking plate comprises a further block (3) having a further thermally conductive, electrically insulating flat layer (7) disposed between said further block (3) and said resistor (2), and elastic pressing means housed in a cavity of said further block (3) and configured so as to force said further flat layer (7) against said resistor (2).

6. Liquid-cooled resistor device (1) as claimed in any preceding claim, **characterised in that** said block (3) is made of an electrically and thermally insulating material.

7. Liquid-cooled resistor device (1) as claimed in any preceding claim, **characterised in that** said block (3) is made of thermoset plastic.

8. Liquid-cooled resistor device (1) as claimed in any preceding claim, **characterised in that** said thermally conductive, electrically insulating flat layer (7) is made of aluminium nitride ceramic.

9. Liquid-cooled resistor device (1) as claimed in any preceding claim, **characterised in that** it comprises expansion guide means disposed between fins of said resistor (2).

10. Liquid-cooled resistor device (1) as claimed in claim 9, **characterised in that** said expansion guide means comprise at least one mica paper strip.

## Patentansprüche

1. Flüssigkeitsgekühlte Widerstandsvorrichtung (1), umfassend einen Block (3), aufweisend einen Flüssigkeitseinlass (4), einen Flüssigkeitsauslass (5) und einen Hohlraum, wobei dieser Hohlraum eine offene Seite aufweist, die durch eine thermisch leitende, elektrisch isolierende flache Schicht (7) abgeschlossen ist, stützend einen flachen Widerstand (2), deren Hauptebenen parallel zueinander ausgerichtet sind, wobei die Vorrichtung zudem eine elektrisch isolierende Spannplatte aufweist, die steif am Block (3) befestigt werden kann und dem Widerstand (2) zugewandt ist, um den Widerstand (2) auf der flachen Schicht (7) festzuspannen, wobei im Hohlraum elastische Pressmittel untergebracht sind, so ausgelegt, dass die flache Schicht (7) gegen den Widerstand (2) gepresst wird, **dadurch gekennzeichnet, dass** der Hohlraum mit einem Flüssigkeitsströmungsweg (6) zwischen dem Flüssigkeitseinlass (4) und dem Flüssigkeitsauslass (5) versehen ist, wobei die elastischen Mittel eine Vielzahl an Federn (8) aufweisen, die im internen Flüssigkeitsströmungsweg (6) des Blocks (3) angeordnet sind.

2. Flüssigkeitsgekühlte Widerstandsvorrichtung (1) nach Anspruch 1, **dadurch gekennzeichnet, dass** die elastischen Pressmittel so ausgelegt sind, dass sie die flache Schicht (7) mit einem fast gleichmäßigen Kontaktdruck am Kontaktbereich dazwischen gegen den Widerstand (2) pressen.

3. Flüssigkeitsgekühlte Widerstandsvorrichtung (1) nach Anspruch 1 oder 2, **dadurch gekennzeichnet, dass** ein jede der Federn (8) so angeordnet ist, dass eine Achse senkrecht zum internen Flüssigkeitsströmungsweg (6) verläuft.

4. Flüssigkeitsgekühlte Widerstandsvorrichtung (1) nach einem der vorhergehenden Ansprüche, **dadurch gekennzeichnet, dass** die Federn (8) aus rostfreiem Stahl bestehen.

5. Flüssigkeitsgekühlte Widerstandsvorrichtung (1) nach einem der vorhergehenden Ansprüche, **dadurch gekennzeichnet, dass** die elektrisch isolierte Spannplatte einen weiteren Block (3) umfasst, aufweisend eine weitere thermisch leitende, elektrisch isolierende flache Schicht (7), die zwischen dem weiteren Block (3) und dem Widerstand (2) angeordnet ist, und elastische Pressmittel, die in einem Hohlraum des weiteren Blocks (3) untergebracht und ausgelegt sind, um die weitere flache Schicht (7) gegen den Widerstand (2) zu pressen.

6. Flüssigkeitsgekühlte Widerstandsvorrichtung (1) nach einem der vorhergehenden Ansprüche, **dadurch gekennzeichnet, dass** der Block (3) aus einem elektrisch und thermisch isolierenden Material besteht.

7. Flüssigkeitsgekühlte Widerstandsvorrichtung (1) nach einem der vorhergehenden Ansprüche, **dadurch gekennzeichnet, dass** der Block (3) aus duroplastischem Kunststoff besteht.

8. Flüssigkeitsgekühlte Widerstandsvorrichtung (1) nach einem der vorhergehenden Ansprüche, **dadurch gekennzeichnet, dass** die thermisch leitende, elektrisch isolierende flache Schicht (7) aus Aluminiumnitridkeramik besteht.

9. Flüssigkeitsgekühlte Widerstandsvorrichtung (1) nach einem der vorhergehenden Ansprüche, **dadurch gekennzeichnet, dass** sie Spreizführungsmittel umfasst, die zwischen den Rippen des Widerstands (2) angeordnet sind.

10. Flüssigkeitsgekühlte Widerstandsvorrichtung (1) nach Anspruch 9, **dadurch gekennzeichnet, dass** die Spreizführungsmittel mindestens einen Glimmerpapierstreifen umfassen.

## Revendications

1. Dispositif de résistance à refroidissement par liquide (1) comprenant un bloc (3) comportant une entrée de liquide (4), une sortie de liquide (5) et une cavité, ladite cavité comportant un côté ouvert fermé par une couche plate (7) thermoconductrice et électriquement isolante supportant une résistance plate (2) ayant leurs plans principaux parallèles l'un à l'autre, ledit dispositif comprenant également une plaque de blocage électriquement isolante, pouvant être fixée rigidement au dit bloc (3), faisant face à ladite résistance (2) pour bloquer ladite résistance (2) sur ladite couche plate (7), ladite cavité logeant des moyens de pression élastiques configurés de manière à forcer ladite couche plate (7) contre ladite résistance (2), **caractérisé en ce que** ladite cavité est pourvue d'une voie de passage de liquide (6) entre ladite entrée de liquide (4) et ladite sortie de liquide (5), lesdits moyens élastiques comprenant une pluralité de ressorts (8) disposés dans ladite voie de passage interne de liquide (6) dudit bloc (3).

2. Dispositif de résistance à refroidissement par liquide (1) selon la revendication 1, **caractérisé en ce que** lesdits moyens de pression élastiques sont configurés de manière à forcer ladite couche plate (7) contre ladite résistance (2) avec une pression de contact presque uniforme au niveau de leurs zones de contact.

3. Dispositif de résistance à refroidissement par liquide (1) selon les revendications 1 ou 2, **caractérisé en ce que** chacun desdits ressorts (8) est disposé avec un axe perpendiculaire à ladite voie de passage interne de liquide (6).

4. Dispositif de résistance à refroidissement par liquide (1) selon l'une quelconque des revendications précédentes, **caractérisé en ce que** lesdits ressorts (8) sont en acier inoxydable.

5. Dispositif de résistance à refroidissement par liquide (1) selon l'une quelconque des revendications précédentes, **caractérisé en ce que** ladite plaque de blocage électriquement isolante comprend un bloc (3) supplémentaire comportant une couche plate (7) thermoconductrice et électriquement isolante supplémentaire disposée entre ledit bloc (3) supplémentaire et ladite résistance (2), et des moyens de pression élastiques logés dans une cavité dudit bloc (3) supplémentaire et configurés de manière à forcer ladite couche plate (7) contre ladite résistance (2).

6. Dispositif de résistance à refroidissement par liquide (1) selon l'une quelconque des revendications précédentes, **caractérisé en ce que** ledit bloc (3) est constitué d'un matériau électriquement et thermiquement isolant.

7. Dispositif de résistance à refroidissement par liquide (1) selon l'une quelconque des revendications précédentes, **caractérisé en ce que** ledit bloc (3) est en plastique thermodurci.

8. Dispositif de résistance à refroidissement par liquide (1) selon l'une quelconque des revendications précédentes, **caractérisé en ce que** ladite couche plate (7) thermoconductrice et électriquement isolante est en céramique de nitrure d'aluminium.

9. Dispositif de résistance à refroidissement par liquide (1) selon l'une quelconque des revendications précédentes, **caractérisé en ce qu'**il comprend des moyens de guidage de détente disposés entre les ailettes de ladite résistance (2).

10. Dispositif de résistance à refroidissement par liquide (1) selon la revendication 9, **caractérisé en ce que** lesdits moyens de guidage de détente comprennent au moins un ruban papier en mica.
